# EUROPEAN PATENT SPECIFICATION

(11) **EP 3 352 545 B1**
(45) Date of publication and mention of the grant of the patent: **16.12.2020**
(21) Application number: 17152407.7
(22) Date of filing: 20.01.2017
(51) Int. Cl.: H05K 5/02, H05K 7/14

(54) **ASSEMBLY HAVING PULL-TYPE LOCKING AND RELEASE STRUCTURE**
ANORDNUNG MIT ZUGVERRIEGELUNGS- UND -ENTRIEGELUNGSSTRUKTUR
ASSEMBLAGE AVEC UNE STRUCTURE DE VERROUILLAGE ET DE LIBÉRATION DU TYPE À TIRETTE

(43) Date of publication of application: 25.07.2018
(73) Proprietor: Dinkle Enterprise Co., Ltd., New Taipei City 24890 (TW); Dinkle Electric Machinery (China) Co., Ltd., Kunshan Jiangsu 215343 (CN)
(72) Inventor: WU, Shang-Tsai, 24890 Wugu Dist., New Taipei City (TW)
(74) Representative: 2K Patentanwälte Blasberg Kewitz & Reichel

(56) References cited:
- DE-U1- 7 819 431
- GB-A- 2 211 241
- US-A- 5 152 496

## Description

### Technical Field

The present invention relates to a housing device and, in particular, to a housing device having a pull-type locking and release structure, whereby a housing can be released quickly and easily with only one hand.

### Background

Electronic devices, like a router, a set-top box, a wireless module, a control module, and a digital input/output device, have different circuit boards inside their housings according to different needs.

Furthermore, the housings of electronic devices normally have one or multiple connection ports like a network port, a video cable port, an audio cable port, and a power port. These connection ports are provided for insertion of related cables/lines. The housings of the electronic devices typically have a rectangular shape. When there is a need to replace or repair components inside the electronic devices, a user has to detach the housing with both hands, which is time-consuming, labor-intensive, and very inconvenient.

US 5 152 496 A discloses a lock structure for a vehicle-mounted type of electronic equipment capable of facilitating the mounting of the electronic equipment on a vehicle and positively locking the electronic equipment with respect to a vehicle. The lock structure includes an equipment lock mechanism, an elastic member for urging the equipment lock mechanism in the direction of a holding section on the side of a vehicle, and an equipment lock release mechanism provided on a handle so as to force the equipment lock mechanism in the released direction when the handle is pivotally moved to a substantially horizontal position.

Accordingly, the target of the inventor is to solve the above-mentioned problems, on the basis of which the present invention is accomplished.

### SUMMARY

It is an object of the present invention to provide assembly having a pull-type locking and release structure, whereby a housing can be released quickly and easily with only one hand.

Accordingly, the present invention provides an assembly comprising a housing device and a casing having a pull-type locking and release structure according to claim 1. The housing device includes a housing and a locking and release member. The housing includes two lateral walls, a breach formed on each of the lateral walls, an elongated groove formed along each of the lateral walls, and a pivot hole formed on each of the lateral walls, wherein each of the pivot holes communicates with a corresponding one of the elongated grooves. The locking and release member includes two arms disposed in the two elongated grooves, a rod connected to the two arms, a resilient element disposed at one end of each of the arms, a connection element connected to each of the arms, a fastening element connected to each of the connection elements, and a pivot protruding from one side of each of the fastening elements. The pivot is pivotally connected to the pivot hole, and the fastening element is rotatable about the pivot. When the rod drives the two arms to move with respect to the elongated grooves, the connection element pushes one end of the fastening element to move, and the other end of the fastening element is away from the breach.

The present invention collaborates with a casing having two fastening holes. The two fastening holes are disposed corresponding to the two breaches. The two fastening elements of the locking and release member are engaged with the two fastening holes, respectively, for assembling the housing to the casing. By means of the lever principle, the pivots of the two fastening elements are fixed in the pivot holes of the housing, a single rod drives movement of the two arms, and the arm drives one end of the fastening element, so that the other end of the fastening element is away from the breach to be disengaged and released from the fastening hole of the casing. Accordingly, the housing device and the casing can be quickly detached or assembled, thereby facilitating maintenance or repairing electronic components inside.

The present invention utilizes the installed or integrally-formed resilient element. Therefore, when a strain pulling the locking and release member is released, the elasticity of the resilient element automatically pushes the corresponding arm and the corresponding connection element. The connection element pushes the corresponding fastening element, so that the fastening elements return to the respective breaches. Accordingly, a user can quickly engage the housing device with the two fastening holes of the casing, in a convenient and time-saving manner.

### BRIEF DESCRIPTION OF THE DRAWINGS

The disclosure will become more fully understood from the detailed description, and the drawings given herein below is for illustration only, and thus does not limit the disclosure, wherein:
FIG. 1 is an exploded view according to the first embodiment of the present invention;
FIG. 2 is a perspective view illustrating a locking and release member according to the first embodiment of the present invention;
FIG. 3 is a perspective view according to the first embodiment of the present invention;
FIG. 4 is a cross-sectional view according to the first embodiment of the present invention;
FIG. 5 is a cross-sectional view showing a first action according to the first embodiment of the present invention;
FIG. 6 is a cross-sectional view showing a second action according to the first embodiment of the present invention;
FIG. 7 is a partial cross-sectional view according to the second embodiment of the present invention;
FIG. 8 is a partial cross-sectional view according to the third embodiment of the present invention;
FIG. 9 is a perspective view according to the third embodiment of the present invention;
FIG. 10 is a partial cross-sectional view according to the fourth embodiment of the present invention;
FIG. 11 is a perspective view illustrating the locking and release member according to the fourth embodiment of the present invention;
FIG. 12 is an exploded view according to the fifth embodiment of the present invention; and
FIG. 13 is a cross-sectional view illustrating the locking and release member according to the fifth embodiment of the present invention.

### DETAILED DESCRIPTION

Detailed descriptions and technical contents of the present invention are illustrated below in conjunction with the accompany drawings. However, it is to be understood that the descriptions and the accompany drawings disclosed herein are merely illustrative and exemplary and not intended to limit the scope of the present invention.

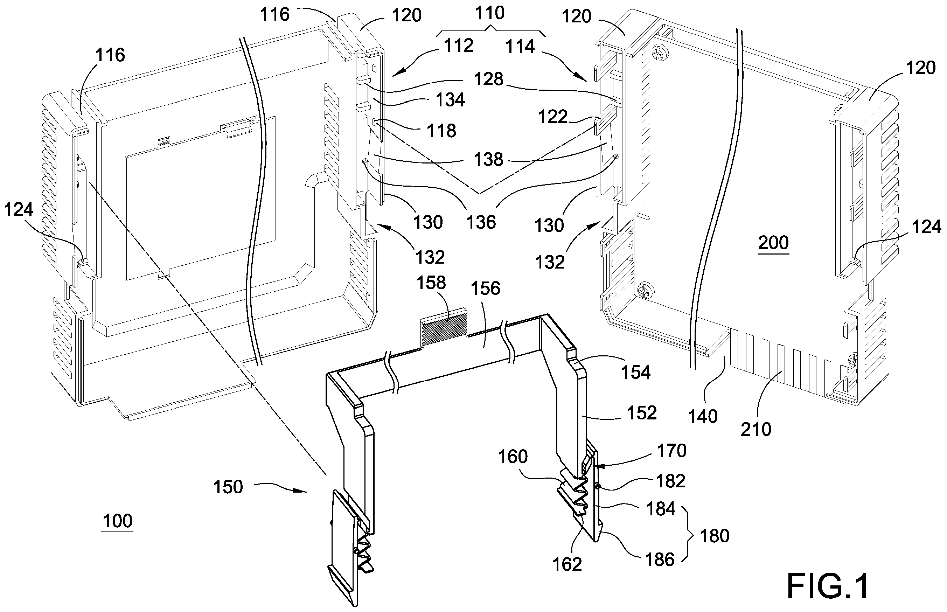

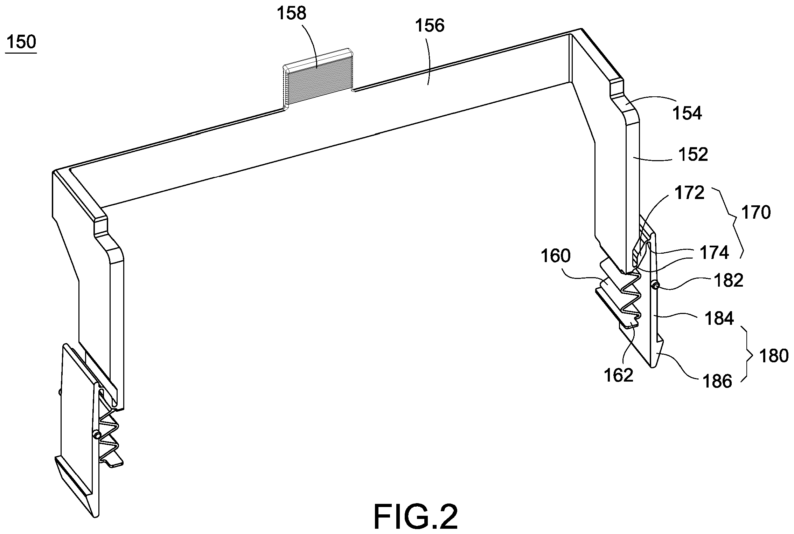

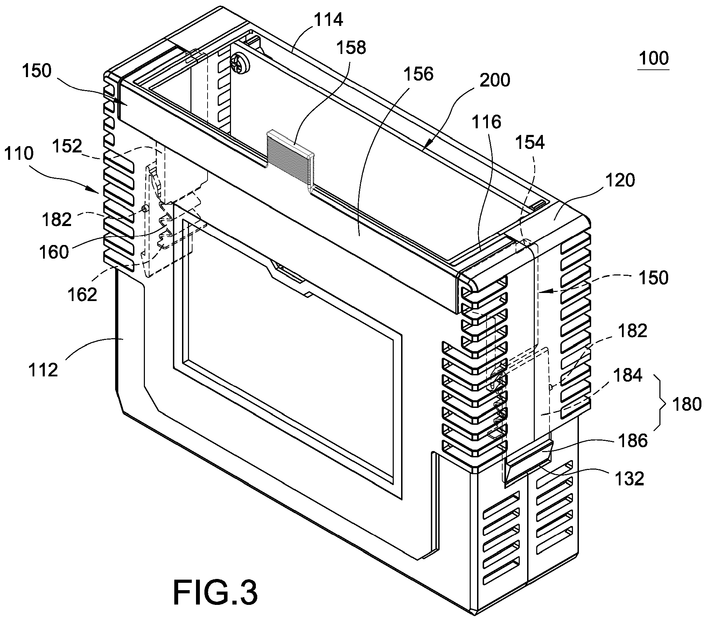

Referring to Figs. 1 to 4, the present invention provides a housing device 100 having a pull-type locking and release structure. The housing device 100 includes a housing 110 and a locking and release member 150. The housing device 100 preferably collaborates with a casing 10 to together constitute an electronic device (not illustrated). The electronic device includes, but not limited to, a router, a set-top box, a wireless module, a control module, a digital input/output device, and even includes an industrial personal computer (IPC) or a programmable logic controller (PLC). However, in other embodiments, the housing device 100 is also applied to the housing 110 of a non-electronic device; the present invention is not limited in this regard.

The housing device 100 further includes a circuit board 200 and an electrical insertion end 210 protruding from one end of the circuit board 200. The housing 110 includes an opening 140, and the electrical insertion end 210 protrudes from the opening 140. When the housing device 100 is assembled to the casing 10, the electrical insertion end 210 is correspondingly inserted in an insertion slot 30 of the casing 10 for electrical connection.

In the present embodiment, the housing 110 includes two lateral walls 130, a breach 132 formed on each of the lateral walls 130, an elongated groove 134 along each of the lateral walls 130, and a pivot hole 136 formed on each of the lateral walls 130. Each of the pivot holes 136 communicates with a corresponding one of the elongated grooves 134. In the embodiment shown in Fig. 1, the housing 110 is preferably made of plastic and is preferably in a rectangular shape. The housing 110 includes a first housing part 112 and a second housing part 114 coupled to each other. The first housing part 112 includes a slot 116 communicating with the elongated groove 134 and includes a plurality of fastening points 118 disposed at the lateral wall 130. The second housing part 114 includes a cover plate 120 covering each of the elongated grooves 134 and includes a plurality of fastening plates 122 disposed corresponding to the fastening points 118 for engagement therewith. The first housing part 112 is coupled to the second housing part 114, and the cover plate 120 is disposed corresponding to the slot 116.

The locking and release member 150 is preferably made of plastic and includes two arms 152 disposed in the two elongated grooves 134, a rod 156 connected to the two arms 152, a resilient element 160 disposed at one end of each of the arms 152, a connection element 170 connected to each of the arms 152, a fastening element 180 connected to each of the connection elements 170, and a pivot 182 protruding from one side of each of the fastening elements 180. The pivot 182 is pivotally connected to the pivot hole 136, and the fastening element 180 is rotatable about the pivot 182. When the rod 156 drives the two arms 152 to move with respect to the elongated groove 134, the connection element 170 pushes one end of the fastening element 180 to move, and the other end of the fastening element 180 is away from the breach 132 to disengage and release the housing 110 from the two fastening holes 20 of the casing 10.

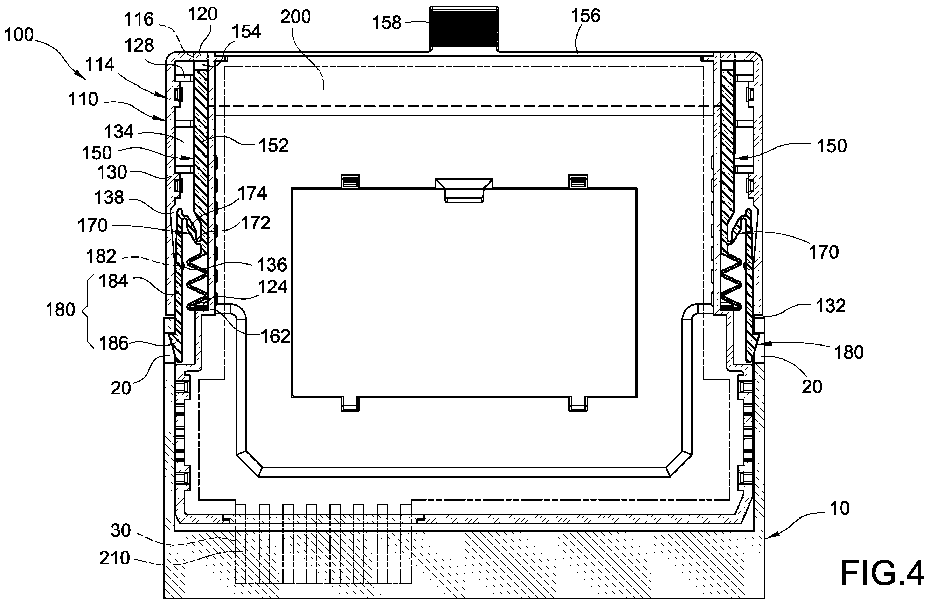

Furthermore, as shown in Fig. 4, the casing 10 has two fastening holes 20 corresponding to the two breaches 132. When the housing device 100 is inserted and connected to the insertion slot 30 of the casing 10, the fastening elements 180 are quickly engaged with the two fastening holes 20 to complete assembling. One end of each of the arms 152 includes an indentation 154, and the housing 110 includes a cover plate 120 disposed corresponding to the indentation 154 and covering the elongated groove 134, so that the arm 152 is inserted through the slot 116, and the indentation 154 is blocked by the cover plate 120. Each of the fastening elements 180 includes a fastening plate 184 and a hook 186 at one end of the fastening plate 184, the pivot 182 protrudes from two sides of the fastening plate 184, and each of the hooks 186 is disposed corresponding to each of the breaches 132 for engagement with each of the fastening holes 20.

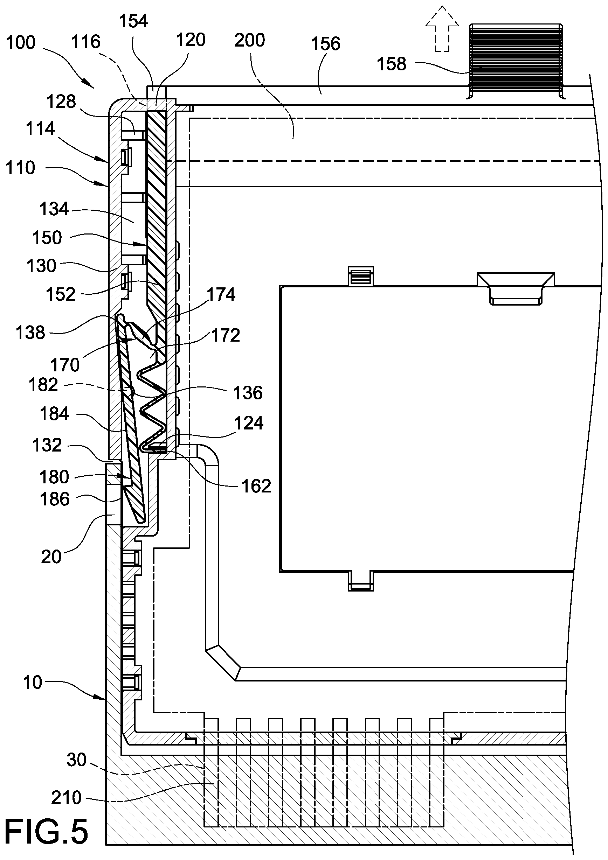

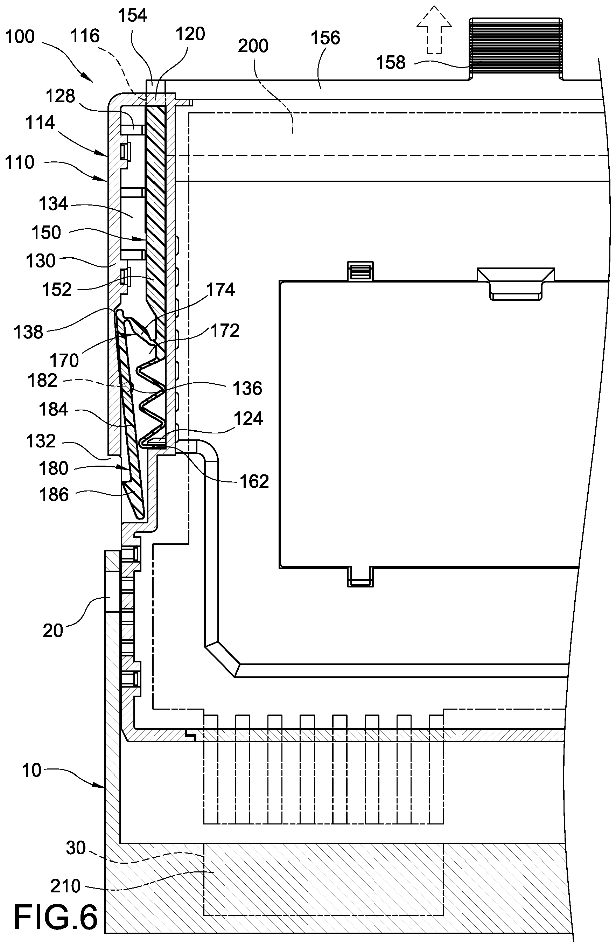

Referring to Figs. 5 and 6, each of the arms 152 is disposed parallel to each of the fastening elements 180. The connection element 170 is connected to the arm 152 and the fastening element 180. The connection element 170 is preferably disposed between the arm 152 and the fastening element 180. Each of the connection elements 170 includes a body 172 and includes two connection ends 174 connected to the arm 152 and the fastening element 180 respectively, and a thickness of the connection end 174 is less than a thickness of the body 172. The connection element 170 made of plastic has a width which preferably corresponds to a width of the arm 152 and a width of the fastening element 180, so the connection element 170 has sufficient strength, and each of the connection ends 174 can be moved easily by movement of the arm 152 or the fastening element 180.

Each of the lateral walls 130 includes a recess 138 adjacent to the pivot hole 136, and the recess 138 receives one end of the fastening element 180. As shown in Figs. 4 to 6, the pivot 182 preferably protrudes from the middle of the fastening plate 184, and thereby the fastening element 180 can rotate about the pivot 182, the recess 138 receives one end of the fastening plate 184, and as a result, the hook 186 can be released from the fastening hole 20.

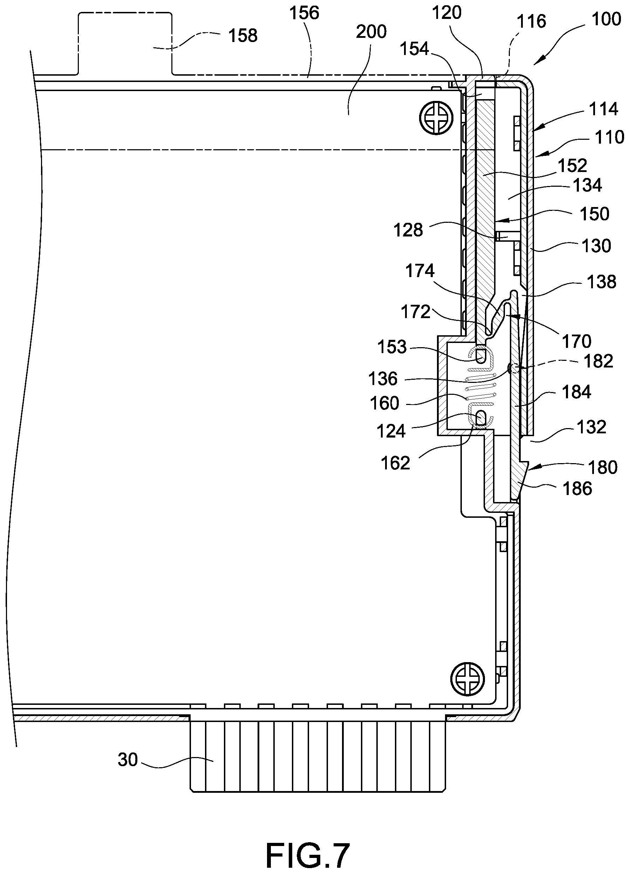

According to the first embodiment, it is preferable that each resilient element 160 and the arm 152 are integrally formed and are made of plastic or suitable materials. The resilient element 160 is preferably a flat spring juxtaposed with the fastening element 180 in the elongated groove 134. In other words, each resilient element 160 is preferably connected to a lower end of each arm 152 in an integral form. However, in the second embodiment shown in Fig. 7, each resilient element 160 can be a tension spring assembled to the lower end of the arm 152. Furthermore, one end of each resilient element 160 includes a positioning end 162, the housing 110 or the arm 152 includes a joining member 124 corresponding to the positioning end 162, the positioning end 162 is engaged with the joining member 124, and thereby the two arms 152 can be elastically restored to their initial positions.

In the first embodiment, the positioning end 124 of the flat spring is an insertion plate, and the joining member 124 of the housing 110 is a positioning block for insertion and fixation of the insertion plate. In the second embodiment, the positioning end 162 of the tension spring is preferably a clasp, and the joining member 124 of the housing 110 is a positioning hole for engagement with the clasp. In Fig. 7, two ends of the tension spring are clasps for engagement with the positioning hole of the housing 110 and a positioning hole of the arm 152 (i.e. a joining member 153).

When a user pulls up the rod 156 of the locking and release member 150, the arm 152 drives the corresponding resilient element 160 and the corresponding connection element 170 to move upward. By means of the lever principle, the fastening element 180 is pushed by the connection element 170 to move toward the recess 138, and the hook 186 is also away from the breach 132 to be disengaged and released from the fastening hole 20. At the same time, the electrical insertion end 210 of the housing device 100 is detached from the insertion slot 30 of the casing 10, thereby facilitating easy and rapid detachment.

It should be noted that, the pivot 182 of the fastening element 180 is fixed in the pivot hole 136, the positioning end 162 of the resilient element 160 is fastened to the joining member 124, and the cover plate 120 of the housing 110 restricts the indentation 154 of each arm 152. Therefore, when the locking and release member 150 is pulled up, the whole housing device 100 is also moved together.

When the user releases the rod 156 of the locking and release member 150, each resilient element 160 elastically restores each arm 152 to its initial position, at the same time each connection element 170 pulls each fastening element 180, and by means of the lever principle, the hook 186 returns to the breach 132. Since the hook 186 of each fastening element 180 has a chamfer (not labelled) at one side, the housing device 100 can be assembled to the casing 10 easily and rapidly after maintenance or repairing of the housing device 100.

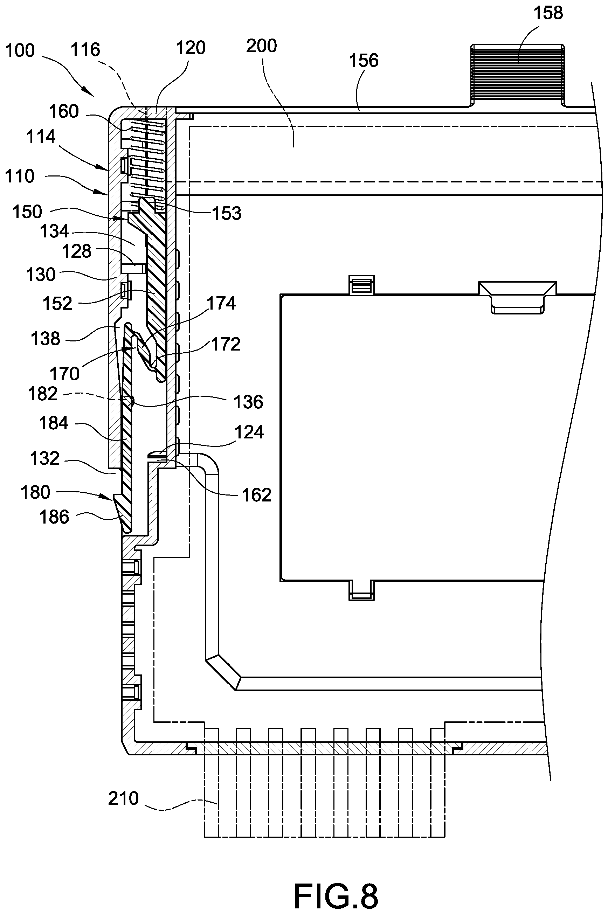

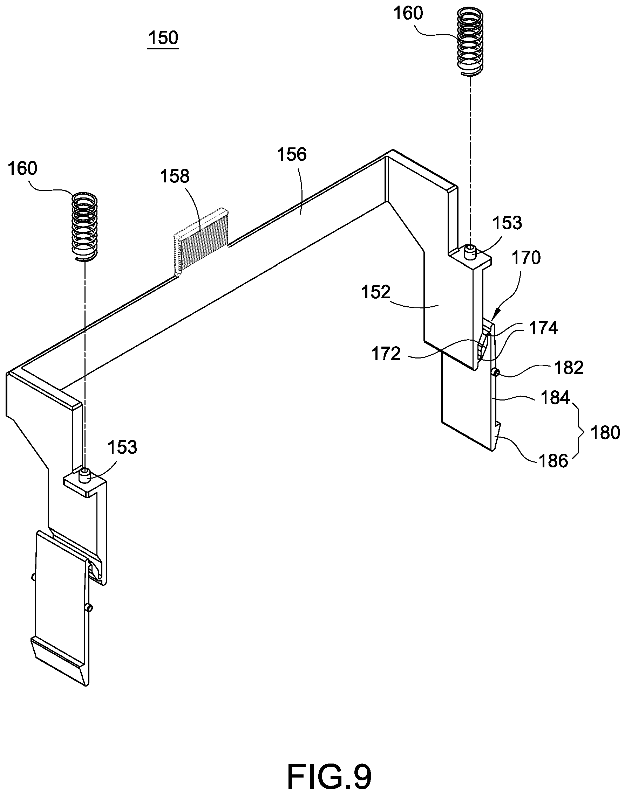

Please refer to Figs. 8 and 9, showing a partial cross-sectional view and a perspective view of the locking and release member according to the third embodiment of the present invention. In the present embodiment, each resilient element 160 is preferably assembled to an upper end of each arm 152, and each arm 152 includes the joining member 153 like a positioning pillar. Each resilient element 160 is preferably a compression spring disposed away from the fastening element 180, one end of the compression spring receives the positioning pillar, and the other end of the compression spring is in contact with the cover plate 120 of the housing 110.

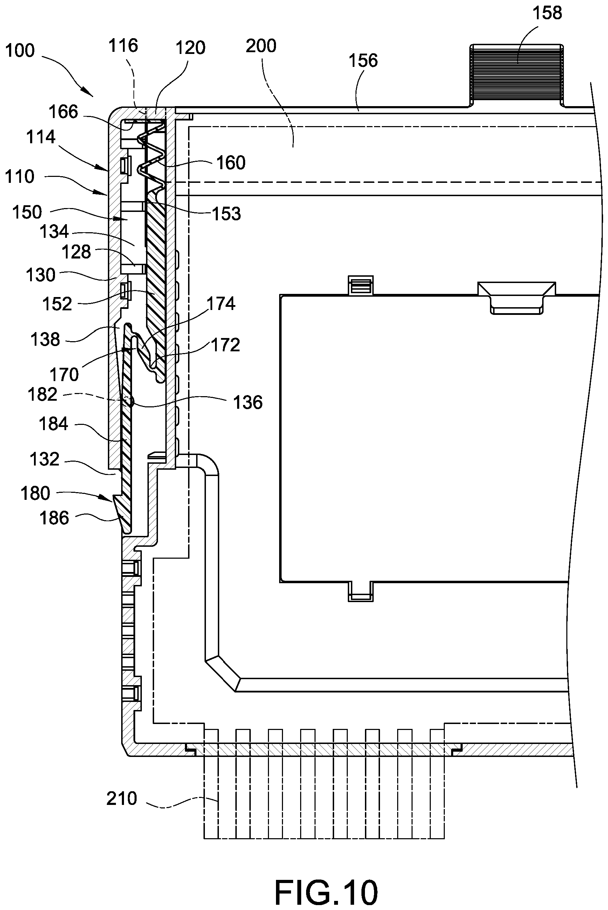

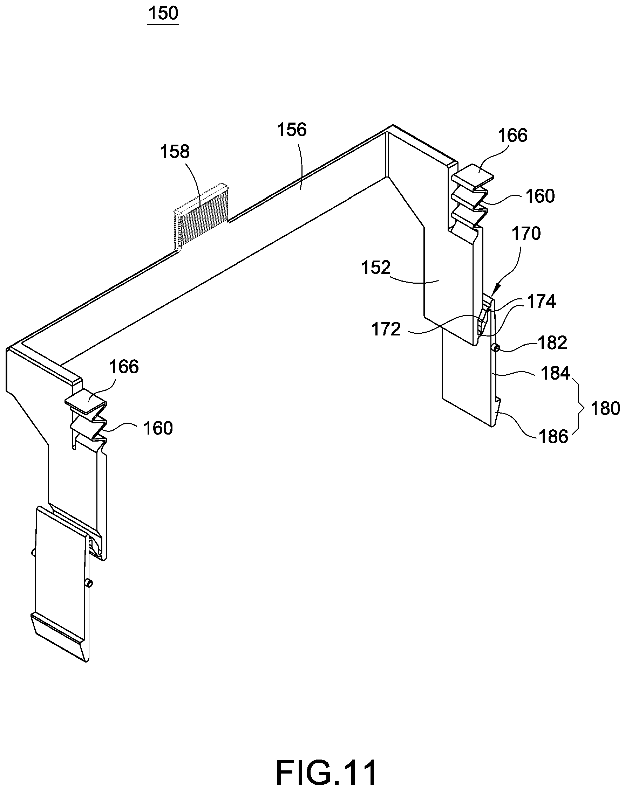

In the fourth embodiment shown in Figs. 10 and 11, each resilient element 160 is preferably a flat spring integrally formed with each arm 152. The present embodiment is different from the first embodiment in that, the flat spring is disposed at the upper end of each arm 152, i.e. away from the fastening element 180. A free end of each resilient element 160 is preferably a contact end 166 in contact with the cover plate 120 for exerting a force to the housing 110 to move it.

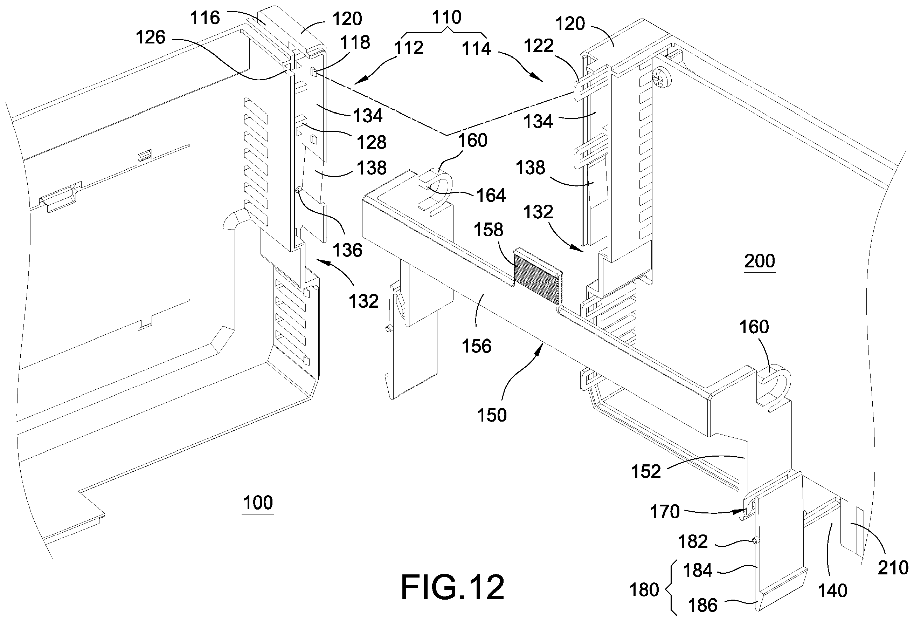

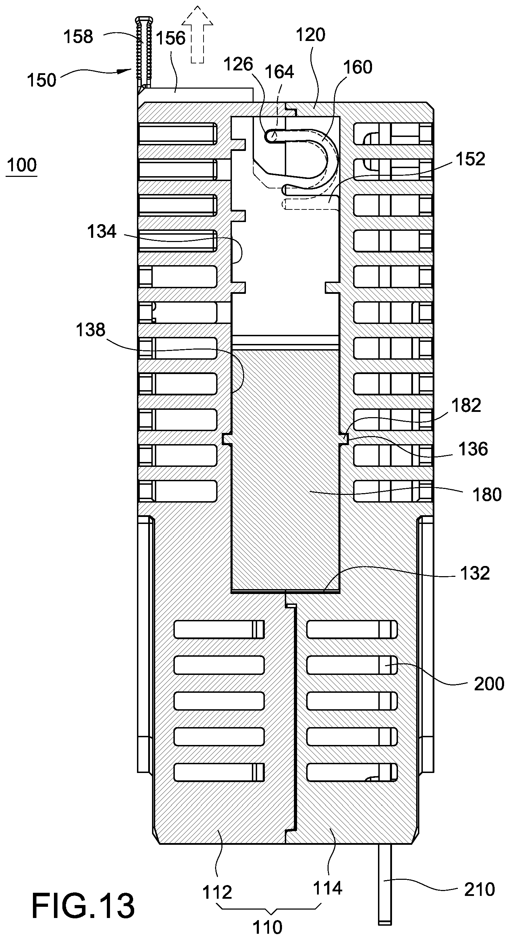

Please refer to Figs. 12 and 13, showing an exploded view and a cross-sectional view according to the fifth embodiment of the present invention. In this embodiment, each resilient element 160 is preferably integrally formed with each arm 152 and is disposed at the upper end of each arm 152. As shown in the drawing, each resilient element 160 is preferably a plate spring in a bent shape. A free end of each plate spring includes a protruding pillar 164 protruding toward the inside of the housing 110, the housing 110 includes a retaining groove 126 corresponding to the protruding pillar 164, so that the protruding pillar 164 is positioned in the retaining groove 126, which provides a force point for the locking and release member 150 to drive movement of the housing 110.

It should be noted that, each of the resilient elements 160 in the first and second embodiments is preferably disposed at the lower end of the arm 152. When each arm 152 is pulled and moved by the rod 156, each resilient element 160 stretches to store energy. In the third, fourth and fifth embodiments, each resilient element 160 is disposed at the upper end of the arm 152. When each arm 152 is pulled and moved by the rod 156, each resilient element 160 is compressed to store the energy. When the rod 156 is released, the stored energy of each resilient element 160 is released to exert an elastic force to restore each fastening element 180 to its initial position. The operations and driving mechanism are described above in the first embodiment.

In order for the user to move the whole housing device 100 by pulling the locking and release member 150 with ease, the locking and release member 150 further includes a handle 158 at one side of the rod 156. The handle 158 is, for example, a pulling plate, a ring or a strap; the present invention is not limited in this regard. Furthermore, in order for the locking and release member 150 to move more stably in the elongated groove 134, the housing 110 further includes a plurality of support blocks 128 disposed at each of the lateral walls 130, and each of the support blocks 128 restrict movement of the respective corresponding arm 152 with respect to the respective corresponding elongated groove 134.

By means of the lever principle, the pivots 182 of the two fastening elements 180 are fixed in the pivot holes 136 of the housing 110, two arms 152 are driven to move by one single rod 156, and each arm 152 pushes one end of the fastening element 180, so that the other end of the fastening element 180 is away from the breach 132 to be disengaged and released from the fastening hole 20 of the casing 10. Accordingly, the housing device 100 can be detached from or assembled to the casing 10 rapidly, thereby facilitating maintenance or other works for electronic components inside.

Furthermore, the present invention utilizes the installed or integrally-formed resilient element 160. Therefore, when a strain pulling the locking and release member 150 is released, the elasticity of the resilient element 160 automatically pushes the corresponding arm 152 and the connection element 170. The connection element 170 pushes the corresponding fastening element 180, so that the fastening elements 180 return to the respective breaches 132. Accordingly, the user can quickly engage the housing device 100 with the two fastening holes 20 of the casing 10, in a convenient and time-saving manner.

## Claims

1. An assembly comprising a housing device and a casing (10) having a pull-type locking and release structure, comprising:
a housing (110), the housing (110) including two lateral walls (130), a notch (132) formed on each of the lateral walls (130) and , an elongated groove (134) formed along each of the two lateral walls (130) of the housing (110) and communicated with the notch (132), a pivot hole (136) formed at the bottom of each elongated groove (134) in the vicinity of the lateral walls (130), and a plurality of support blocks (128) disposed at each of the lateral walls;
and
a locking and release member (150), the locking and release member (150) including two arms (152) disposed in the two elongated grooves (134), a rod (156) connected to the two arms (152), a resilient element (160) disposed at one end of each of the arms (152), a connection element (170) connected to each of the arms (152), a fastening element (180) connected to each of the connection elements (170), and a pivot (182) protruding from one side of each of the fastening elements (180),
the casing (10), having two fastening holes (20) corresponding to the two notches (132), wherein when the housing device is inserted in the casing (10), the fastening elements (180) are engaged with the two fastening holes (20) to complete assembling;
wherein the pivot (182) is pivotally connected to the pivot hole (136), and when a user pulls up the rod (156) of the locking and release member (150), the rod (156) drives the two arms (152) to move with respect to the elongated grooves (134) and each of the support blocks (128) restricts movement of the respective corresponding arm (152) with respect to the respective corresponding elongated groove (134), the connection element (170) pushes one end of the fastening element (180) to move, and another end of the fastening element (180) is away from the notch (132) to be disengaged and released from the fastening hole (20) of the casing (10) ; and when the user releases the rod (156) of the locking and release member (150), each resilient element (160) elastically restores each arm (152) to its initial position.

2. The assembly having the pull-type locking and release structure of claim 1, wherein each of the arms (152) is parallel to each of the fastening elements (180), and the connection element (170) is connected to the arm (152) and the fastening element (180).

3. The assembly having the pull-type locking and release structure of claim 2, wherein each of the connection elements (170) includes a body (172) and includes two connection ends (174) connected to the arm (152) and the fastening element (180) respectively, and a thickness of the connection end (174) is less than a thickness of the body (172).

4. The assembly having the pull-type locking and release structure of any of the claims 1 to 3, wherein each of the lateral walls (130) includes a recess (138) adjacent to the pivot hole (136), and the recess (138) receives one end of the fastening element (180).

5. The assembly having the pull-type locking and release structure of any of the claims 1 to 4, wherein one end of each of the arms (152) includes an indentation (154), and the housing (110) includes a cover plate (120) disposed corresponding to each of the indentations (154) and covering each of the elongated grooves (134).

6. The assembly having the pull-type locking and release structure of any of the claims 1 to 5, wherein each of the fastening elements (180) includes a fastening plate (184) and a hook (186) at one end of the fastening plate (184), the pivot (182) protrudes from at least one side of the fastening plate (184), and each of the hooks (186) is disposed corresponding to each of the breaches (132).

7. The assembly having the pull-type locking and release structure of any of the claims 1 to 6, wherein one end of each of the resilient elements (160) includes a positioning end (162), the housing (110) or each of the arms (152) includes a joining member (124) corresponding to the positioning end (162), and the positioning end (162) is engaged with the joining member (124).

8. The assembly having the pull-type locking and release structure of claim 7, wherein the positioning end (162) is an insertion plate or a clasp, and the joining member (124) is a positioning block, a positioning hole or a positioning pillar.

9. The assembly having the pull-type locking and release structure of any of the claims 1 to 8, wherein each of the resilient elements (160) is integrally formed with each of the arms (152).

10. The assembly having the pull-type locking and release structure of claim 9,
wherein each of the resilient elements (160) is a flat spring or a plate spring and preferably, wherein a free end of the flat spring further includes a protruding pillar (164), and the housing (110) includes a retaining groove (126) corresponding to the protruding pillar (164).

11. The assembly having the pull-type locking and release structure of any of the claims 1 to 10, wherein the resilient element (160) is a compression spring or a tension spring installed at one end of the arm (152),
and preferably wherein a free end of the resilient element (160) is a contact end (166) in contact with the housing (110).

12. The assembly having the pull-type locking and release structure of any of the claims 1 to 11, wherein the locking and release member (150) further includes a handle (158) at one side of the rod (156).

13. The assembly having the pull-type locking and release structure of any of the claims 1 to 12, further comprising a circuit board (200) and an electrical insertion end (210) protruding from one end of the circuit board (200), the housing (110) including an opening (140), the electrical insertion end (210) protruding from the opening (140).

14. The assembly having the pull-type locking and release structure of any of the claims 1 to 13, wherein the housing (110) includes a first housing part (112) and a second housing part (114) coupled to each other
and preferably wherein the first housing part (112) includes two slots (116) communicating with the two elongated grooves (134) respectively and includes a plurality of fastening points (118) disposed at the lateral wall (130), the second housing part (114) includes a cover plate (120) covering each of the elongated grooves (134) and includes a plurality of fastening plates (122) disposed corresponding to the fastening points (118), and the cover plate (120) is disposed corresponding to the slot (116).

## Patentansprüche

1. Eine Baugruppe mit einer Gehäusevorrichtung und einem Gehäuse (10) mit einer Verriegelungs- und Freigabeelement, umfassend:
ein Gehäuse (110), wobei das Gehäuse (110) zwei Seitenwände (130), eine Kerbe (132), die an jeder der Seitenwände (130) ausgebildet ist, und , eine längliche Nut (134), die entlang jeder der beiden Seitenwände (130) des Gehäuses (110) ausgebildet ist und mit der Kerbe (132) in Verbindung steht, ein Schwenkloch (136), das am Boden jeder länglichen Nut (134) in der Nähe der Seitenwände (130) ausgebildet ist, und eine Vielzahl von Stützblöcken (128), die an jeder der Seitenwände angeordnet sind, umfasst; und
ein Verriegelungs- und Freigabeelement (150), wobei das Verriegelungs- und Freigabeelement (150) zwei Arme (152), die in den beiden länglichen Nuten (134) angeordnet sind, eine Stange (156), die mit den beiden Armen (152) verbunden ist, ein elastisches Element (160), das an einem Ende jedes der Arme (152) angeordnet ist, ein Verbindungselement (170), das mit jedem der Arme (152) verbunden ist, ein Befestigungselement (180), das mit jedem der Verbindungselemente (170) verbunden ist, und einen Drehzapfen (182), der von einer Seite jedes der Befestigungselemente (180) vorsteht, aufweist,
wobei das Gehäuse (10) zwei Befestigungslöcher (20) aufweist, die den beiden Kerben (132) entsprechen, **dadurch gekennzeichnet, dass**, wenn die Aufnahmevorrichtung in das Gehäuse (10) eingeführt wird, die Befestigungselemente (180) mit den beiden Befestigungslöchern (20) in Eingriff gebracht werden, um den Zusammenbau zu vervollständigen;
wobei der Drehzapfen (182) schwenkbar mit dem Zapfenloch (136) verbunden ist, und wenn ein Benutzer die Stange (156) des Verriegelungs- und Freigabeelements (150) nach oben zieht, treibt die Stange (156) die beiden Arme (152) zur Bewegung in Bezug auf die Längsnuten (134) an, und jeder der Stützblöcke (128) begrenzt die Bewegung des jeweils entsprechenden Arms (152) in Bezug auf die jeweils entsprechende Längsnut (134), das Verbindungselement (170) ein Ende des Befestigungselements (180) zur Bewegung drückt, und ein anderes Ende des Befestigungselements (180) von der Kerbe (132) entfernt ist, um aus dem Befestigungsloch (20) des Gehäuses (10) gelöst und freigegeben zu werden; und wenn der Benutzer die Stange (156) des Verriegelungs- und Freigabeelements (150) freigibt, stellt jedes elastische Element (160) jeden Arm (152) elastisch in seine Ausgangsposition zurück.

2. Die Baugruppe mit der Zugverriegelungs- und Freigabestruktur nach Anspruch 1, wobei jeder der Arme (152) parallel zu jedem der Befestigungselemente (180) ist und das Verbindungselement (170) mit dem Arm (152) und dem Befestigungselement (180) verbunden ist.

3. Die Baugruppe mit der Zugverriegelungs- und Freigabestruktur nach Anspruch 2, wobei jedes der Verbindungselemente (170) einen Körper (172) und zwei Verbindungsenden (174) aufweist, die mit dem Arm (152) bzw. dem Befestigungselement (180) verbunden sind, und eine Dicke des Verbindungsendes (174) geringer ist als eine Dicke des Körpers (172).

4. Die Baugruppe mit der Zugverriegelungs- und Freigabestruktur nach einem der Ansprüche 1 bis 3, wobei jede der Seitenwände (130) eine Aussparung (138) neben dem Schwenkloch (136) aufweist und die Aussparung (138) ein Ende des Befestigungselements (180) aufnimmt.

5. Die Baugruppe mit der Zugverriegelungs- und Freigabestruktur nach einem der Ansprüche 1 bis 4, wobei ein Ende jedes Arms (152) eine Einkerbung (154) aufweist und das Gehäuse (110) eine Abdeckplatte (120) aufweist, die entsprechend jeder der Einkerbungen (154) angeordnet ist und jede der länglichen Nuten (134) abdeckt.

6. Die Baugruppe mit der Zugverriegelungs- und Freigabestruktur nach einem der Ansprüche 1 bis 5, wobei jedes der Befestigungselemente (180) eine Befestigungsplatte (184) und einen Haken (186) an einem Ende der Befestigungsplatte (184) aufweist, der Zapfen (182) von mindestens einer Seite der Befestigungsplatte (184) vorsteht und jeder der Haken (186) entsprechend jedem der Durchbrüche (132) angeordnet ist.

7. Die Baugruppe mit der Zugverriegelungs- und Freigabestruktur nach einem der Ansprüche 1 bis 6, wobei ein Ende jedes der elastischen Elemente (160) ein Positionierungsende (162) aufweist, das Gehäuse (110) oder jeder der Arme (152) ein Verbindungselement (124) aufweist, das dem Positionierungsende (162) entspricht, und das Positionierungsende (162) mit dem Verbindungselement (124) in Eingriff steht.

8. Die Baugruppe mit der Zugverriegelungs- und Freigabestruktur nach Anspruch 7, wobei das Positionierungsende (162) eine Einführungsplatte oder ein Verschluss ist und das Verbindungselement (124) ein Positionierungsblock, ein Positionierungsloch oder eine Positionierungssäule ist.

9. Die Baugruppe mit der Zugverriegelungs- und Freigabestruktur nach einem der Ansprüche 1 bis 8, wobei jedes der elastischen Elemente (160) einstückig mit jedem der Arme (152) ausgebildet ist.

10. Die Baugruppe mit der Zugverriegelungs- und Freigabestruktur nach Anspruch 9, wobei jedes der elastischen Elemente (160) eine Flachfeder oder eine Blattfeder ist,
und vorzugsweise, wobei ein freies Ende der Flachfeder ferner eine vorstehende Säule (164) aufweist und das Gehäuse (110) eine Haltenut (126) aufweist, die der vorstehenden Säule (164) entspricht.

11. Die Baugruppe mit der Zugverriegelungs- und Freigabestruktur nach einem der Ansprüche 1 bis 10, wobei das elastische Element (160) eine Druckfeder oder eine Zugfeder ist, die an einem Ende des Arms (152) installiert ist,
und wobei vorzugsweise ein freies Ende des elastischen Elements (160) ein Kontaktende (166) in Kontakt mit dem Gehäuse (110) ist.

12. Die Baugruppe mit der Zugverriegelungs- und Freigabestruktur nach einem der Ansprüche 1 bis 11, wobei das Verriegelungs- und Freigabeelement (150) ferner einen Griff (158) an einer Seite der Stange (156) aufweist.

13. Die Baugruppe mit der Zugverriegelungs- und Freigabestruktur nach einem der Ansprüche 1 bis 12, ferner mit einer Leiterplatte (200) und einem elektrischen Einsetzende (210), das von einem Ende der Leiterplatte (200) vorsteht, wobei das Gehäuse (110) eine Öffnung (140) aufweist und das elektrische Einsetzende (210) aus der Öffnung (140) vorsteht.

14. Die Baugruppe mit der Zugverriegelungs- und Freigabestruktur nach einem der Ansprüche 1 bis 13, wobei das Gehäuse (110) ein erstes Gehäuseteil (112) und ein zweites Gehäuseteil (114) aufweist, die miteinander verbunden sind
und wobei vorzugsweise das erste Gehäuseteil (112) zwei Schlitze (116) aufweist, die jeweils mit den beiden länglichen Nuten (134) in Verbindung stehen, und eine Vielzahl von Befestigungspunkten (118) aufweist, die an der Seitenwand (130) angeordnet sind, das zweite Gehäuseteil (114) eine Abdeckplatte (120) aufweist, die jede der länglichen Nuten (134) abdeckt und eine Vielzahl von Befestigungsplatten (122) aufweist, die entsprechend den Befestigungspunkten (118) angeordnet sind, und die Abdeckplatte (120) entsprechend dem Schlitz (116) angeordnet ist.

## Revendications

1. Un assemblage comprenant un dispositif de logement et un boîtier ayant une structure de verrouillage et de libération du type à tirette, comprenant:
un boîtier (110), le boîtier (110) comprenant deux parois latérales (130), une encoche (132) formée sur chacune des parois latérales (130) et, une rainure allongée (134) formée le long de chacune des deux parois latérales (130) du boîtier (110) et communiquant avec l'encoche (132), un trou pivot (136) formé au bas de chacune des rainures allongées (134) dans le voisinage des parois latérales (130), et une pluralité de blocs support (128) disposés au niveau de chacune des parois latérales ;
et
un élément de verrouillage et de libération (150), l'élément de verrouillage et de libération (150) comprenant deux bras (152) disposés dans les deux rainures allongées (134), une tige (156) reliée aux deux bras (152), un élément élastique (160) disposé à une extrémité de chacun des bras (152), un élément de liaison (170) relié à chacun des bras (152), un élément de fixation (180) relié à chacun des éléments de liaison (170), et un pivot (182) faisant saillie d'un côté de chacun des éléments de fixation (180),
le boîtier (10) ayant deux trous de fixation (20) correspondant aux deux encoches (132) dans lequel lorsque le dispositif de logement est inséré dans le boîtier (10), les éléments de fixation (180) sont en prise avec les deux trous de fixation (20) pour compléter l'assemblage ;
dans lequel le pivot (182) est relié de manière pivotante au trou de pivot (136), et lorsqu'un utilisateur tire sur la tige (156) de l'élément de verrouillage et de libération (150), la tige (156) entraîne les deux bras (152) en mouvement par rapport aux rainures allongées (134) et chacun des blocs support (128) retient le mouvement du bras correspondant respectif (152) par rapport à la rainure allongée correspondante respective (134), l'élément de liaison (170) pousse une extrémité de l'élément de fixation (180) pour un mouvement, et une autre extrémité de l'élément de fixation (180) s'éloigne de la rainure (132) pour sortir de prise et être libéré du trou de fixation (20) du boîtier (10); et lorsque l'utilisateur relâche la tige (156) de l'élément de verrouillage et de libération (150), chaque élément élastique (160) rétablit de manière élastique chaque bras (152) à sa position initiale.

2. L'assemblage ayant une structure de verrouillage et de libération du type à tirette de la revendication 1, dans lequel chacun des bras (152) est parallèle à chacun des éléments de fixation (180), et l'élément de liaison (170) est connecté au bras (152) et à l'élément de fixation (180).

3. L'assemblage ayant une structure de verrouillage et de libération du type à tirette de la revendication 2, dans lequel chacun des éléments de liaison (170) comprend un corps (172) et comprend deux extrémités de liaison (174) reliées au bras (152) et à l'élément de fixation (180) respectivement, et une épaisseur de l'extrémité de connexion (174) est inférieure à une épaisseur du corps (172).

4. L'assemblage ayant une structure de verrouillage et de libération du type à tirette de l'une quelconque des revendications 1 à 3, dans lequel chacune des parois latérales (130) comprend un évidement (138) adjacent au trou de pivot (136), et l'évidement (138)) reçoit une extrémité de l'élément de fixation (180).

5. L'assemblage ayant une structure de verrouillage et de libération du type à tirette de l'une quelconque des revendications 1 à 4, dans lequel une extrémité de chacun des bras (152) comprend une indentation (154), et le boîtier (110) comprend une plaque de recouvrement (120) disposée en correspondance avec chacune des indentations (154) et recouvrant chacune des rainures allongées (134).

6. L'assemblage ayant une structure de verrouillage et de libération du type à tirette de l'une quelconque des revendications 1 à 5, dans lequel chacun des éléments de fixation (180) comprend une plaque de fixation (184) et un crochet (186) à une extrémité de la plaque de fixation (184), le pivot (182) faisant saillie d'au moins un côté de la plaque de fixation (184), et chacun des crochets (186) étant disposé en correspondance avec chacune des brèches (132).

7. L'assemblage ayant une structure de verrouillage et de libération du type à tirette de l'une quelconque des revendications 1 à 6, dans lequel une extrémité de chacun des éléments élastiques (160) comprend une extrémité de positionnement (162), le boîtier (110) ou chacun des éléments les bras (152) comprennent un élément de jonction (124) correspondant à l'extrémité de positionnement (162), et l'extrémité de positionnement (162) est en prise avec l'élément de jonction (124).

8. L'assemblage ayant une structure de verrouillage et de libération du type à tirette de la revendication 7, dans lequel l'extrémité de positionnement (162) est une plaque d'insertion ou un fermoir, et l'élément de jonction (124) est un bloc de positionnement, un trou de positionnement ou un pilier de positionnement.

9. L'assemblage ayant une structure de verrouillage et de libération du type à tirette de l'une quelconque des revendications 1 à 8, dans lequel chacun des éléments élastiques (160) est formé d'un seul tenant avec chacun des bras (152).

10. L'assemblage ayant une structure de verrouillage et de libération du type à tirette de la revendication 9, dans lequel chacun des éléments élastiques (160) est un ressort plat ou un ressort à lame et de préférence, dans lequel une extrémité libre du ressort plat comprend en outre un pilier saillant (164), et le boîtier (110) comprend une rainure de retenue (126) correspondant au pilier en saillie (164).

11. L'assemblage ayant une structure de verrouillage et de libération du type à tirette de l'une quelconque des revendications 1 à 10, dans lequel l'élément élastique (160) est un ressort de compression ou un ressort de tension installé à une extrémité du bras (152), et de préférence dans lequel une extrémité libre de l'élément élastique (160) est une extrémité de contact (166) en contact avec le boîtier (110).

12. L'assemblage ayant une structure de verrouillage et de libération du type à tirette de l'une quelconque des revendications 1 à 11, dans lequel l'élément de verrouillage et de libération (150) comprend en outre une poignée (158) sur un côté de la tige (156).

13. L'assemblage ayant une structure de verrouillage et de libération du type à tirette de l'une quelconque des revendications 1 à 12, comprenant en outre une carte de circuit imprimé (200) et une extrémité d'insertion électrique (210) faisant saillie à partir d'une extrémité de la carte de circuit (200), le boîtier (110) comprenant une ouverture (140), l'extrémité d'insertion électrique (210) dépassant de l'ouverture (140).

14. L'assemblage ayant une structure de verrouillage et de libération du type à tirette de l'une quelconque des revendications 1 à 13, dans lequel le boîtier (110) comprend une première partie de boîtier (112) et une seconde partie de boîtier (114) couplées l'une à l'autre et de préférence dans lequel la première partie de boîtier (112) comprend deux fentes (116) communiquant avec les deux rainures allongées (134) respectivement et comprend une pluralité de points de fixation (118) disposés au niveau de la paroi latérale (130), la deuxième partie de boîtier (114) comprend une plaque de recouvrement (120) recouvrant chacune des rainures allongées (134) et comprend une pluralité de plaques de fixation (122) disposées en correspondance avec les points de fixation (118), et la plaque de recouvrement (120) est disposée en correspondance avec la fente (116)).
